Europäisches Patentamt

European Patent Office

Office européen des brevets

(19)

(11) Publication number: **0 044 572**
**A1**

(12) # EUROPEAN PATENT APPLICATION

(21) Application number: **81105842.9**

(22) Date of filing: **23.07.81**

(51) Int. Cl.³: **G 01 R 33/032**
**G 01 R 15/07**

(30) Priority: **23.07.80 JP 99966/80**

(43) Date of publication of application:
**27.01.82 Bulletin 82/4**

(84) Designated Contracting States:
**DE FR GB NL**

(71) Applicant: **Hitachi, Ltd.**
**5-1, Marunouchi 1-chome**
**Chiyoda-ku Tokyo 100(JP)**

(72) Inventor: **Matsumura, Hiroyoshi**
**264-61, Ohaza-Kubo Hidaka-cho**
**Iruma-gun Saitama-ken(JP)**

(72) Inventor: **Katsuyama, Toshio**
**1-47-1, Akatsuki-cho**
**Hachioji-shi Tokyo(JP)**

(72) Inventor: **Suganuma, Tsuneo**
**5-17-5, Nakaarai Tokorozawa-shi**
**Saitama-ken(JP)**

(74) Representative: **Strehl, Peter K.L. Schiff, Dr. A.v.**
**Füner et al,**
**Dipl. Ing. P. Strehl Dr. U. Schübel-Hopf Dipl. Ing.**
**D.Ebbinghaus Dr. Ing. D. Finck Patentanwälte**
**Mariahilfplatz 2&3**
**D-8000 München 90(DE)**

(54) Apparatus for measuring the intensity of magnetic fields by an optical fiber.

(57) An apparatus for measuring the intensity of a magnetic field includes a measuring detector composed of an optical fiber coil (4). The radius R of the coil (4) is defined by the following Equation:

$$R = \frac{2(m+1)L}{2},$$

wherein m denotes an integer and L denotes the length at which the birefringency of the optical fiber becomes $2\pi$.

*FIG. 1*

EP 0 044 572 A1

EPA- 25 485

APPARATUS FOR MEASURING THE INTENSITY OF MAGNETIC FIELDS
BY AN OPTICAL FIBER

BACKGROUND OF THE INVENTION

(1)   Field of the Invention

The present invention relates to an apparatus for measuring the intensity of magnetic fields by means of an optical fiber, and more particularly to an apparatus for measuring the intesity or variation of the magnetic field in a small space, a space into which it is difficult to insert an electric conductive line or the like, by means of an optical fiber.

(2)   Description of the Prior Art

In the prior art, there has been known a technique, by which the polarization plane of light propagated through an optical fiber is rotated by the Faraday effect due to a magnetic field applied in order either to maintain a high voltage or current equipment or to detect any trouble or malfunction of the device.

The magnetic field detecting apparatus using light is advantageous over the measuring apparatus using an electric conductive coil in that isolation is so excellent that    accurate detection can be performed without disturbing the magnetic field of the equipment.

However, the measuring apparatus using the optical fiber as  proposed by the prior art has a  high voltage electric wire wound with the optical fiber or a  magnetic field generating coil wound with the optical fiber in order to measure the magnetic field.  Therefore, the labor involved in winding the optical fiber upon the wire or coil used in the equipment tc be measured makes the apparatus inconvenient to produce and use, and it is difficult to wind the optical optical fiber in a restricted space.

SUMMARY OF THE INVENTION

It is, therefore, an object of the present invention to provide an apparatus for accurately measuring the intensity of a magnetic field in a small space by means of an optical fiber without requiring winding the optical fiber upon an electric conductive line or coil  or adversely affecting other parts.

In order to attain the aforementioned object, according to the present invention, there is provided an apparatus, in which  polarized light is applied to a detecting coil (or detector) disposed in a magnetic field and made of an optical fiber thereby to measure the intensity of the magnetic field in terms of the rotation of the polarization plane at the detecting coil by the magnetic field, and which is characterized in that the aforementioned detecting coil is formed into a coil made of the optical fiber, and in that the total length of the optical fiber constructing the coil is made a multiple of an odd number of the length L, at which the birefringence intrinsic to the optical fiber is $2\pi$. For example, if the coil is made circular, the apparatus of the invention is further characterized in that the radius R of the circle is expressed by the following Equation: $R = (2m + 1)L/2\pi$. Here, the word "substantially" implies that a little compensation is required because strain is usually generated, if the optical fiber is bent, so that the birefringence intrinsic to the optical fiber is a little varied.

Here, the birefringence intrinsic to the optical fiber has a relationship with the difference $\Delta\beta$ between the propagation constants of the two waves with linear polarization, which propagate along the perpendicular principle axes of the optical fiber, and with the length z of the optical fiber and is expressed by the product of $\Delta\beta$ and z.

On the other hand, the number of turns of the coil is sufficient if it exceeds one, and the detection sensitivity is generally improved if the number of turns is increased. Nevertheless, the number of turns is determined in relation to the size or the like of the coil actually used.

With the construction thus far described, according to the present invention, it is sufficient merely to insert the coil into the space of the device to be measured, but it is unnecessary to wind the coil on the conductor, coil or the like constructing the device to be measured, whereby it becomes easy to insert and mount the magnetic field detecting apparatus in the device to be measured. Moreover, the coil constructed of the optical fiber has such a small volume , e.g. about 0.5 $cm^3$, that it can be inserted into a remarkably small space. For example, any trouble, malfunction or the like of a transformer can be detected by inserting the coil into the space between the primary and secondary windings of the transformer thereby to detect an abnormal magnetic field, if any.

The above-mentioned and other objects and features of the present invention will become apparent from the following description taken in conjunction with the accompanying drawings.

BRIEF DESCRIPTION OF THE DRAWINGS

Fig. 1 is a view showing the construction of one embodiment of an apparatus for measuring the intensity of a magnetic field according to the present invention;

Fig. 2 is a view showing the construction of a detecting coil used in the aforementioned embodiment;

Figs. 3, 4 and 5 are explanatory views showing the polarization plane in an optical fiber for explaining the principle of the present invention;

Fig. 6 is a graph showing the magnetic fields as measured by the magnetic field measuring apparatus according to the present invention; and

Fig. 7 is a sectional view showing the optical fiber used in the embodiment shown in Fig. 1.

DESCRIPTION OF THE PREFERRED EMBODIMENTS

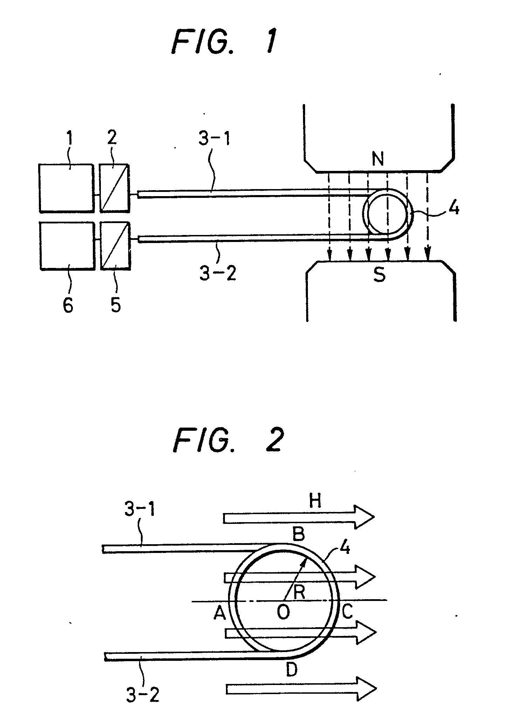

Fig. 1 is a view showing an example of the overall construction of the magnetic field measuring apparatus to which the present invention is applied. The light emitted from a coherent light source 1 is polarized by a polarizer 2 to have its wave polarized in a predetermined direction and is guided into an optical fiber 3-1. This optical fiber 3-1 is coupled to a backpass optical fiber 3-2 through a magnetic field detecting coil 4 which is formed at the end portion of the optical fiber 3-1. The light emanating from the terminal of the optical fiber 3-2 is coupled through a light detector 5 to a light receiver 6, and the detecting coil 4 is inserted into the magnetic field to be measured (which will be called "a magnetic field applied portion"). The magnetic field is indicated by magnetic poles N and S in Fig. 1 for simplicity of explanation, but it is sufficient if there is a space in which a magnetic field exists. By holding constant the polarizing angles of the aforementioned polarizer 2 and detector 5, the polarization plane is rotated by the intensity of the magnetic field, while the light propagates through the optical fiber, especially, the detecting coil 4, so that the intensity of the magnetic field can be detected by detecting the rotation in terms of the light. Incidentally, the constructions of the light source 1 and the receiver 6 are well known in the art, and their detailed explanation is omitted.

The present invention is directed especially to the construction of the detecting coil 4 so that the construction of the light detecting unit should not be limited to the aforementioned example but may be different. Fig. 2 is a view showing the construction of one embodiment of the detecting coil forming an essential portion of the present invention. Midway of the transmission path optical fibers 3-1 and 3-2, which are made of such an optical fiber which holds the polarization plane in a predetermined direction, the optical fiber 4, which is made of such a material as is subjected to the Faraday effect, is formed into a circle having a diameter of R, i.e., into a coil shape. The number of turns of the coil should be at least one. Moreover, the radius is determined to satisfy the following Equation: $R = (2m + 1)L/2\lambda$, wherein

m = 0, 1, 2, 3, - - -. Here, letter L denotes the length at which the birefringency of the optical fiber 4 forming the coil is $2\pi$.

More specifically, if the phase speeds of the light propagating along the two perpendicular optical principle axes $\underline{x}$ and $\underline{y}$ in the section of the optical fiber are denoted $\beta_{\underline{x}}$ and $\beta_{\underline{y}}$, there is the following relationship between $\Delta\beta = \beta_{\underline{x}} - \beta_{\underline{y}}$ and the length L:

$$L = \frac{2\pi}{\Delta\beta}.$$

The fact that there is a difference between $\beta_{\underline{x}}$ and $\beta_{\underline{y}}$ comes from the fact that the optical fiber has different refractive indices along the aforementioned principle axes, i.e. has a birefrigency.

It is usually convenient for production that the transmission path optical fibers 3-1 and 3-2 and the detecting coil fiber 4 are made of an identical fiber. Moreover, although the aforementioned embodiment is directed for simplicity of explanation to the case in which the coil is circular, this coil may be oval. Generally speaking, it is sufficient that the total length of the optical fiber forming the coil is made a multiple of an odd number of the length L.

If the detecting coil thus made is arranged in a magnetic field H (which is indicated by blanked arrows), the rotation of the polarization plane takes place in a manner corresponding to the intensity of the magnetic field by a reason which will be described in detail in the following, so that the accurate measurement can be performed even with a weak magnetic field. The principle of the present invention will now be described by the use of a straight optical fiber for simplicity of explanation.

In an optical fiber having an intense polarization plane holding property, i.e., in an optical fiber in which the difference in phase speeds between the light beams propagating along the perpendicular principle axes in a section thereof is large, the polarization plane in the fiber propagates along the principle axes if polarized light coincident with the principle axes is introduced.

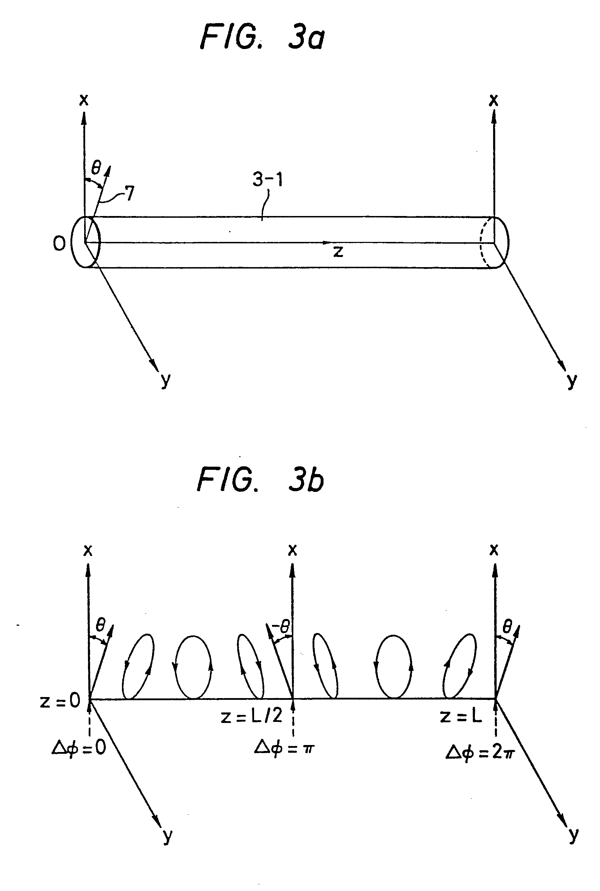

As shown in Fig. 3(a), the x and y axes in a plane normal to the propagation direction are used as the principle axes of birefringency of the optical fiber 3-1. In other words, if waves with linear polarization polarized in the direction of the x axis is incident, the output waves are waves with linear polarization polarized in the direction of the x axis. Waves with linear polarizations propagating along those principle axes (i.e., the x and y axes) become different in their phase speeds. As a result, if waves with linear polarization 7

at an angle $\theta$ with respect to one of the principle axes, e.g. the x axis, are incident, the polarization condition on the section of the optical fiber is changed into a linear, oval or other polarization along the optical fiber axis z, as shown in Fig. 3(b), in accordance with the aforementioned difference in the phase speeds. These polarization characteristics vary periodically so that the same linear polarization occurs at $\Delta\phi = 2m\pi$ (m = 0, 1, 2, 3, - - -), as shown in Fig. 3(b), if the birefringency is denoted at $\Delta\phi$, and the linear polarization at an inverse angle $-\theta$ with respect to the x axis occurs at $\Delta\phi = (2m + 1)\pi$. The oval polarization is obtained at an intermediate location. The birefrigency $\phi$ of the optical fiber has a relationship with the difference between the propagation constants of the two waves with linear polarization, which propagate along the principle axes, and with the length z of the optical fiber and is expressed by $\Delta\phi = \Delta\beta \cdot z$. Especially, the length of the optical fiber for $\Delta\phi = 2\pi$ is denoted at L in Fig. 3(b).

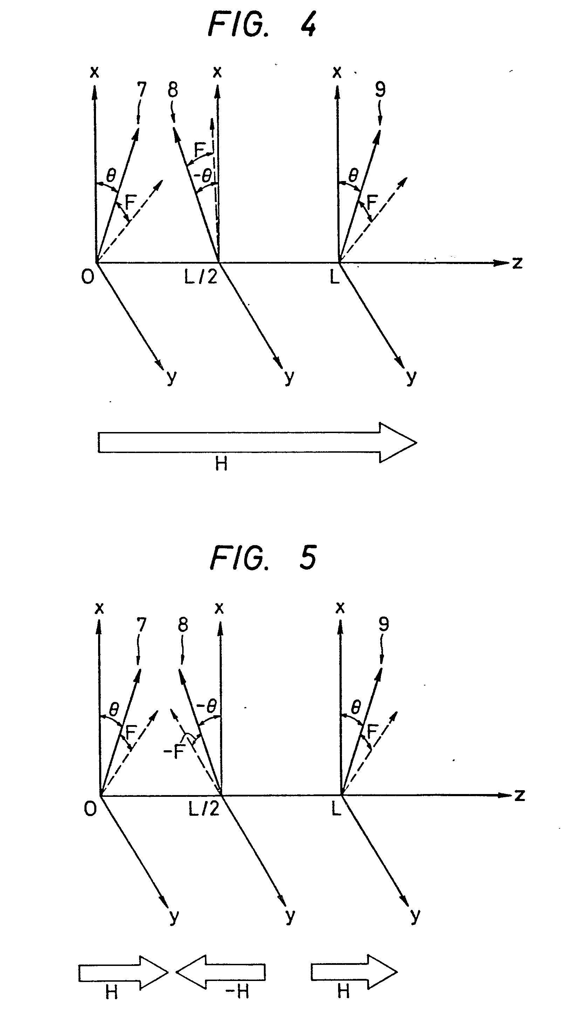

Here, the fact that the Faraday effect has its apparent characteristics reduced if the magnetic field is applied to the fiber having birefringency will be described in the following. Generally speaking, if a magnetic field is applied to the optical fiber, the linearly polarized light is rotated by the Faraday effect of the material used. Here, as shown in Fig. 4, it is assumed that a uniform magnetic field having an intensity H is applied to a birefrigent fiber. The linearly polarized lights 7, 8 and 9 are rotated in a predetermined direction by the action of that magnetic field. It is assumed that the direction of rotation is clockwise and that the intensity is F radian. At this time, the linearly polarized lights 7 and 9 are rotated $\theta$ + F radian so that the angle of rotation is increased. At the position where the length of the optical fiber is L/2, they are rotated $\theta$ - F radian so that the angle of rotation is decreased. More specifically, at the position where the length of the optical fiber is mL, the Faraday rotation of the magnetic fields rotates the polarization plane of the light. At the position of $(m + \frac{1}{2})L$, the Faraday rotation acts to suppress the rotation. As a result, the highly birefrigent fiber performs a small apparent Faraday rotation. Consequently, the detection sensitivity to the magnetic field is deteriorated.

If, however, magnetic fields in the opposite directions are applied at the positions of $(m + \frac{1}{2})L$ and mL, as shown in Fig. 5, the angle of rotation due to the Faraday effect is added at every position so that the Faraday effect is integrated in the longitudinal direction. In other words, the detection sensitivity to the magnetic field becomes remarkably high.

This will be explained by the use of Equations. It is assumed that the birefringency of the optical fiber is $2\pi$ at the position where the length of the fiber is L, as shown in Figs. 4 and 5. If waves with linear polarization in the direction of the $\underline{x}$ axis at z = 0 are incident, the components of the electric field in the directions of the $\underline{x}$ and $\underline{y}$ axes at z = L are expressed by the following Equation:

$$\begin{pmatrix} E_x \\ E_y \end{pmatrix} = \begin{pmatrix} A & \mp B \\ \pm B & A^* \end{pmatrix} \begin{pmatrix} A & -B \\ B & A^* \end{pmatrix} \begin{pmatrix} \exp(j\omega t) \\ 0 \end{pmatrix} \quad \cdots (1)$$

wherein: $*$ : Complex Conjugate;

$\omega$ : Angular Frequency of Light;

t : Time Term; and

$E_{\underline{x},\underline{y}}$ : Components of Electric Field on $\underline{x}$ and $\underline{y}$ axes at z = L.

Here, A and B are expressed by the use of the Faraday rotation F (radian) and the birefringency $\Delta\phi = 2\pi$, as follows:

$$A = \cos\{F^2 + (\tfrac{\pi}{2})^2\}^{\frac{1}{2}}$$

$$+ j \frac{(\tfrac{\pi}{2})}{[F^2 + (\tfrac{\pi}{2})^2]^{\frac{1}{2}}} \sin[F^2 + (\tfrac{\pi}{2})^2]^{\frac{1}{2}} \quad \cdots (2)$$

$$B = \frac{F}{[F^2 + (\tfrac{\pi}{2})^2]^{\frac{1}{2}}} \sin[F^2 + (\tfrac{\pi}{2})^2]^{\frac{1}{2}}$$

As to the symbols $\pm$ appearing in the matrix of the Equation (1), it is assumed that the upper symbol + indicates that the intensity H of the magnetic field is in the direction in which the light propagates, as shown in Fig. 4, and that the lower symbol - indicates that alternations take place, as shown in Fig. 5. It may be usually assumed that the Faraday angle of rotation F is less than 0.05 radian and that the following inequality holds:

$$F << \frac{\pi}{2} \qquad \cdots (3)$$

Hence, the Equation (2) can be approximated into the following Equations:

$$A = -\frac{F^2}{\pi} + j$$
$$B = \frac{2F}{\pi} \qquad \cdots (4)$$

If the Equation (4) is substituted into the Equation (1), the output $|E_y|^2$ is remarkably small in the order of $F^6$ and is substantially zero in the construction of Fig. 4 (that is to say, the upper symbol of the matrix in the Equation (1) is taken). In the construction of Fig. 5, on the contrary, the following Equation holds:

$$|E_y|^2 = (\frac{2F}{\pi})^2 \qquad \cdots (5)$$

and it is found that there is no suppression of the Faraday effect.

If the combinations of applying the magnetic field alternately in opposite directions, as shown in Fig. 5, are taken N times, by the calculation:

$$\begin{pmatrix} E_x \\ E_y \end{pmatrix} = \underbrace{\begin{pmatrix} A & B \\ -B & A^* \end{pmatrix}\begin{pmatrix} A & -B \\ B & A^* \end{pmatrix}}_{N} \underbrace{\begin{pmatrix} A & B \\ -B & A^* \end{pmatrix}\begin{pmatrix} A & -B \\ -B & A^* \end{pmatrix}}_{N-1} \cdots$$

$$\cdots \underbrace{\begin{pmatrix} A & B \\ -B & A^* \end{pmatrix}\begin{pmatrix} A & -B \\ B & A^* \end{pmatrix}}_{2} \underbrace{\begin{pmatrix} A & B \\ -B & A^* \end{pmatrix}\begin{pmatrix} A & -B \\ B & A^* \end{pmatrix}}_{1} \begin{pmatrix} \exp(j\omega t) \\ 0 \end{pmatrix}$$

$$\cdots (6)$$

the following Equation is obtained by the use of the approximation of the Equation (4):

$$|E_y|^2 = \left( N \cdot \frac{2F}{\pi} \right)^2 \qquad \cdots (7)$$

This fact indicates that the Faraday effect is accumulated if the number of the times of the alternate repetitions is increased.

It is found from the foregoing description that there is an accumulated effect of the Faraday effect if the magnetic fields to be applied to the optical fiber are oriented in opposite directions at a frequency at which the birefringency of the optical fiber is $2\pi$.

Although the foregoing description is directed for simplicity of explanation to the case in which a straight optical fiber is used, the magnetic field

actually measured is not such an alternate one as is shown in Fig. 5. However, in case the optical fiber is made circular, as shown in Fig. 2, equivalence to Fig. 5 can be obtained. Specifically, the upper half (A → B → C) of the circle of Fig. 2 corresponds to the portions 7 and 9 in Fig. 5, whereas the lower half (C → D → A) corresponds to the portion 8 in Fig. 5. Thus, a large rotation of the polarization plane can be obtained by winding the optical fiber into the coil shape so that the measurement can be performed even for a weak magnetic field.

Incidentally, although the foregoing description is directed to the case in which the upper semicircle has a length of L/2, it is generally sufficient that the length is (2m + 1)L/2. In other words, it is sufficient that the radius R of the coil is expressed by R = (2m + 1)L/2π.

As is natural, incidentally, in order to perform the measurement of the magnetic field by making use of the rotation of the polarization plane of the light due to the Faraday effect, it is indispensable that the rotation of the polarization plane is not effected by any other external disturbances (e.g. occasional bending of the optical fiber or fluctuations such as vibrations). Therefore, the optical fiber has to hold the polarization plane. Such a polarization plane holding fiber is a fiber which has a high birefringency, as has been described hereinbefore.

More specifically, if B is equal to or smaller than 10 mm, the polarization plane is not influenced by the usual external disturbances, but is held when the radius R of the aforementioned coil is equal to or larger than 10 mm.

If, on the other hand, the optical fiber is bent, the birefringency intrinsic to the fiber is a little varied, which sometimes requires some variation of the radius R in accordance with the bending radius.

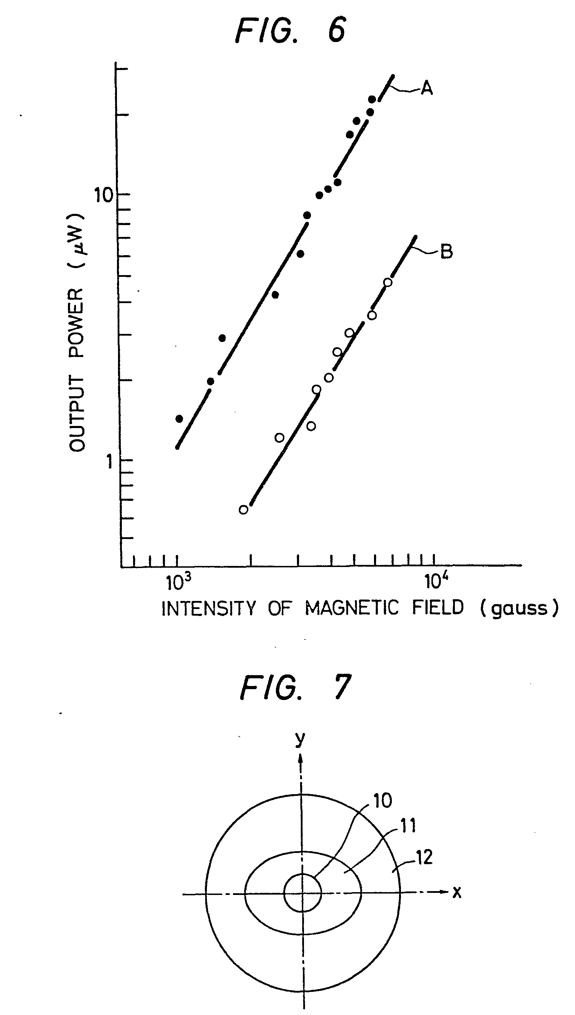

Fig. 6 shows the magnetic field measured by the magnetic field measuring apparatus according to the present invention.The abscissa indicates the intensity (Gauss) of the magnetic field applied,and the ordinate indicates the detected output [πW].

More specifically, waves with linear polarization are introduced into the optical fiber 3-1 of Fig. 1 in the direction of one of the perpendicular principle axes of the optical fiber 3-1, and the light emanating from the optical fiber 3-2 is detected by the detector 5 at a right angle with respect to that principle axis. In case the detecting coil 4 is not inserted into a magnetic field, the emanating light is completely shielded , and the output when the coil is inserted into a magnetic field and when the magnetic field is varied is detected.

Fig. 7 is a section of the optical fiber used for the aforementioned optical fibers 3-1 and 3-2 and the detecting coil 4. The core 10 is made of silica doped with 12 mol % of $P_2O_5$ and 5 mol % of $GeO_2$, the cladding 11 is made of silica doped with 4 mol % of $P_2O_5$, and the jacket 12 is made of silica. The reason why the cladding 11 is oval is to make the core 10 birefringent. Such optical fiber can be easily realized by the modified chemical vapor deposition (MCVD) method which is well known in the art. The standardized frequency of the aforementioned optical fiber is 24 for a wavelenght of 0.6333 µm, and the length L for a birefringency of $2\lambda$ is about 63 mm. On the other hand, the radius of the detecting coil is 10 mm. In Fig. 6, the straight line A indicates the case, in which a detecting coil having six turns is used, whereas the straight line B indicates the case, in which a detecting coil having three turns is used. As is apparent from Fig. 6, the output is correctly detected with the square of the intensity of the magnetic field. Moreover, it is indicated that the output is increased with the increase in the number of turns of the coil.

The present invention is not limited to the aforementioned embodiment, but the optical fiber may be any if it has such an intense birefringency effecting the Faraday rotation.

Patent_claims

1.  An apparatus for measuring the intensity of a magnetic field, comprising: means (1, 2) for generating polarized light; a detector (4) for rotating the polarization plane of the light due to a magnetic field; a first transmission path (3-1) for transmitting the polarized light from the generating means (1) to said detector (4); light receiving means (5, 6) for detecting the output light of said detector (4); and a second transmission path (3-2) for transmitting the output of said detector (4) to said light receiving means (5, 6), c h a r a c t e r i z e d   in that said detector (4) is formed of an optical fiber wound into a coil shape, and in that the length of the optical fiber wound into the coil shape is a multiple of an odd number of the length L, at which the birefringence intrinsic to said optical fiber is 2 π.

2.  The apparatus of claim 1, c h a r a c t e r i z e d in that the coil shape is a circle having a radius R expressed by the following Equation:

$$R = \frac{(2m + 1)L}{2\pi} ,$$

wherein m is an integer.

3. The apparatus of claim 1 or 2, c h a r a c t e - r i z e d   in that the optical fibers of said first and second transmission paths (3-1, 3-2) and of said detector (4) are constructed of an identical optical fiber.

4. The apparatus of any of the claims 1 to 3, c h a - r a c t e r i z e d   in that said optical fiber includes a core (10) of silicate glass doped with phosphorous pentoxide ($P_2O_5$) and germanium oxide ($GeO_2$), a cladding (11) of silicate glass doped with phosphorous pentoxide ($P_2O_5$), and a jacket (12) of silicate glass.

5. The apparatus of any one of claims 1 to 4, c h a - r a c t e r i z e d   in that means for generating the polarized light is constructed of a light emitting element (11) and a polarizing element (12), and that said light receiving means is constructed of a light detecting element (5) and a light receiving device (6) which are at a predetermined angle with respect to the polarization plane of said polarizing element (2).

*FIG. 1*

*FIG. 2*

## FIG. 3a

## FIG. 3b

0044572

## FIG. 4

## FIG. 5

4/4

0044572

FIG. 6

FIG. 7

**0044572**

European Patent Office

**EUROPEAN SEARCH REPORT**

Application number

EP 81105842.9

## DOCUMENTS CONSIDERED TO BE RELEVANT

| Category | Citation of document with indication, where appropriate, of relevant passages | Relevant to claim |
|---|---|---|
| X | DE – A1 – 2 624 692 (GENERAL ELECTRIC)<br><br>+ Claim 1 +<br><br>-- | 1,3,5 |
| X | DE – B2 – 2 835 794 (MAX PLANCK GES.)<br><br>+ Claim 1; fig. 1 +<br>& GB-A-2 033 601<br><br>-- | 1,3,5 |
| X | DE – A1 – 2 855 337 (LICENTIA)<br><br>+ Claims 2,3; fig. 1b +<br><br>-- | 1 |
| X | GB – A – 1 269 102 (NIPPON SELFOC)<br><br>+ Page 1, lines 59-71; page 3, lines 6-12; page 3, line 54 – page 4, line 37; claim 1; fig. 3 +<br><br>-- | 1,4 |
| X | US – A – 3 756 690 (CORNING GLASS)<br><br>+ Fig. 2; abstract +<br><br>---- | 1,3,5 |

**CLASSIFICATION OF THE APPLICATION (Int. Cl.³)**

G 01 R 33/032
G 01 R 15/07

**TECHNICAL FIELDS SEARCHED (Int. Cl.³)**

G 01 R 15/00
G 01 R 33/00
G 02 B 5/00
G 02 F 1/00

**CATEGORY OF CITED DOCUMENTS**

X: particularly relevant
A: technological background
O: non-written disclosure
P: intermediate document
T: theory or principle underlying the invention
E conflicting application
D: document cited in the application
L: citation for other reasons

&. member of the same patent family.
corresponding document

| | The present search report has been drawn up for all claims | |
|---|---|---|
| Place of search<br>VIENNA | Date of completion of the search<br>30-10-1981 | Examiner<br>KUNZE |

EPO Form 1503.1  06.78